# EUROPEAN PATENT SPECIFICATION

(11) **EP 1 786 254 B1**
(45) Date of publication and mention of the grant of the patent: **07.05.2008**
(21) Application number: 06123664.2
(22) Date of filing: 08.11.2006
(51) Int. Cl.: H05K 13/04

(54) **Linear multiple feeder for automatic SMD electronic components positioning apparatuses**
Mehrfache Linearzuführvorrichtung für automatische Vorrichtungen zur Positionierung von elektronischen SMD Bauteilen
Dispositif d'alimentation linéaire multiple pour appareils de positionnement automatique de composants electroniques de type SMD

(30) Priority: 14.11.2005 IT FI20050232
(43) Date of publication of application: 16.05.2007
(73) Proprietor: LCM S.r.l, 54033 Carrara (Massa) (IT)
(72) Inventor: Arrighi, Claudio, 54036 Carrara (Massa) (IT)
(74) Representative: Bardini, Marco Luigi

(56) References cited:
- DE-A1- 4 137 193
- US-A- 4 494 902
- US-A- 4 586 670
- US-A- 4 657 158
- US-A- 5 515 600

## Description

The present invention relates to the field of machinery for automatically positioning SMD electronic components, commonly known as "pick and place" machines, and, more particularly, the invention concerns a linear multiple feeder for feeding SMD to such machines.

As is known, surface-mounting technologies are processes used in the manufacture of electronic circuits, which involve the use of surface mounted devices (SMD) of increasingly limited dimensions. SMD are installed by computer-controlled automatic pick and place machines with one or more picking and placing heads, which collect the components from suitable feeders and deposit them in the required position on the printed circuit.

Feeders are used to make the SMD ready for collection from their packaging. The feeders open the packages and present the components at a required position so that they can be collected by a positioning head.

There are various types of packaging, the most widespread of which is the type using tape wound on reels. In this case, the feeder is used to feed the tape forward by means of holes punched in the tape and to separate and wind up the film applied over the tape to cover the recesses containing the components.

Two main solutions have been developed to feed the tape forward and retrieve the film: the first involves the tape being driven forward by the stepping rotation of a gear wheel; the second involves a system using linear actuators.

Pneumatic actuators have been used in the gear wheel delivery systems, in which levering devices are used to turn the gear wheel to feed the tape carrying the SMD forward and simultaneously operate a system that retrieves the film. Electrical actuators have also been used instead of pneumatic actuators. Linear delivery systems generally involve the use of a linear electric actuator, which drives a carriage complete with retractable pins designed to engage in the holes in the tape, and thereby entrain the tape together with the carriage, and then become disengaged therefrom at the beginning of the carriage's return stroke. Such solutions have been used both for single feeders, i.e. where each tape is installed on a separate delivery device, and for multiple feeders, i.e. where several tapes are contained in the same unit and a common actuator is used to drive them forward with a system for selecting only the tape(s) that have been programmed for delivery.

The main drawback of the above described feeder systems lies in that highly complex configurations are necessary to obtain a high operating precision, with consequently high costs. In the case of the gear wheel type of feeder, moreover, the wheel must be able to engage in tapes of different thicknesses around an arc of a circle, which means that some degree of slack must be allowed between the diameter of the tooth and a hole in the tape: this poses problems of positioning repeatability when different tapes are used. Moreover, in the case of a machine with single-actuating feeders having to perform multiple pickups, i.e. when the machine's pickup heads descend simultaneously onto a number of exposed SMD, a mechanical adjustment system is needed to enable the alignment of the different feeders. Therefore, in machines with gear wheel type multiple feeders, adjustment means have to be provided on each wheel to guarantee the precision needed for multiple pickups.

In a linear feed multiple feeder of known type, a mechanical housing structure contains a linear electrical actuator capable of driving a carriage with a plurality of retractable pins, i.e. that rise and fall due to the effect of respective electromagnetic actuators. The selective engagement of the pins enables only the required tapes to be moved forward together with the carriage. After the forward motion the activated carriage returns to the resting position. In this type of feeder, the film covering the SMD is lifted away from one side to enable the component to be picked up and the film exits from the front of the feeder, still attached to the tape, which is now empty on the other side. In practical terms, as the tape moves forward, it encounters a shaped blade that detaches the film from the tape along one side of the latter, raising it enough to expose the SMD. This solution entails a significant increase in the dimensions and structural complexity of the feeder, while failing to eliminate the risk of the tape moving. In addition, the tapes are more complicated to feed and the system is sensitive to any differences in the way the film is attached to the tape as a result of manufacturing defects or aging of the adhesive.

The object of the present invention is to provide a linear multiple feeder for automatic SMD positioning machines that enables a highly precise exposure of the components for simultaneous pickups, ensuring several pickup heads descending simultaneously onto the feeder to collect a number of suitably exposed and perfectly aligned SMD.

Another object of the present invention is to provide a linear multiple feeder of the aforesaid type that is less expensive and smaller in size than comparable feeders of known type with an equivalent performance.

A further object of the present invention is to provide a linear multiple feeder of the aforesaid type whose reliability and precision are unaffected by highly numerous operating cycles.

These objects are achieved by the linear multiple feeder according to the present invention, the essential characteristics of which are set forth in claim 1. Further important features are set forth in the dependent claims.

The linear multiple feeder for SMD automatic positioning machines according to the invention comprises a supporting structure, a plurality of reels of tapes carrying the SMD revolvingly installed on the supporting structure, means for the retrieval of the protective film detached from the tapes when the SMD components are exposed for collection, a plurality of parallel lanes for the delivery of the tapes provided on the supporting structure, downstream from the means for retrieving the film, and a device for the linear forward delivery of the tapes along the lanes, comprising a carriage alternately moving between two stops and carrying a row of tape-entraining pins selectively engageable in the tapes inside the lanes so as to carry only the selected tapes forward as necessary. In the lanes there are respective elements for separating the coating film, which is axially drawn along by the retrieval means, in the opposite direction to the delivery of the respective tape, in order to detach the film from the forward-moving tape, forcing it against the separator elements, the tension created in the coating film by film retrieval means being suitable for pushing the separators against the bottom of their respective lanes and thereby prevent any movement of the tapes that have not been selected for delivery, by locking them between the separators and the bottom of the lane.

The characteristics and advantages of the linear multiple feeder for automatic SMD positioning machines according to the present invention are explained more clearly in the following description of an exemplifying non-limiting embodiment thereof, with reference to the attached drawings, wherein:
- figure 1 is a perspective view of the feeder according to the present invention;
- figure 2 is a partial lateral cross-section of the feeder of figure 1;
- figure 3 is an enlarged perspective view of the front part of the feeder of figure 1;
- figure 4 is a longitudinal sectional view of the feeder of figure 1;
- figure 5 is a top plan view of the front part of the feeder shown in figure 3;
- figure 6 is an enlarged view of the side wall of the pick-up station.

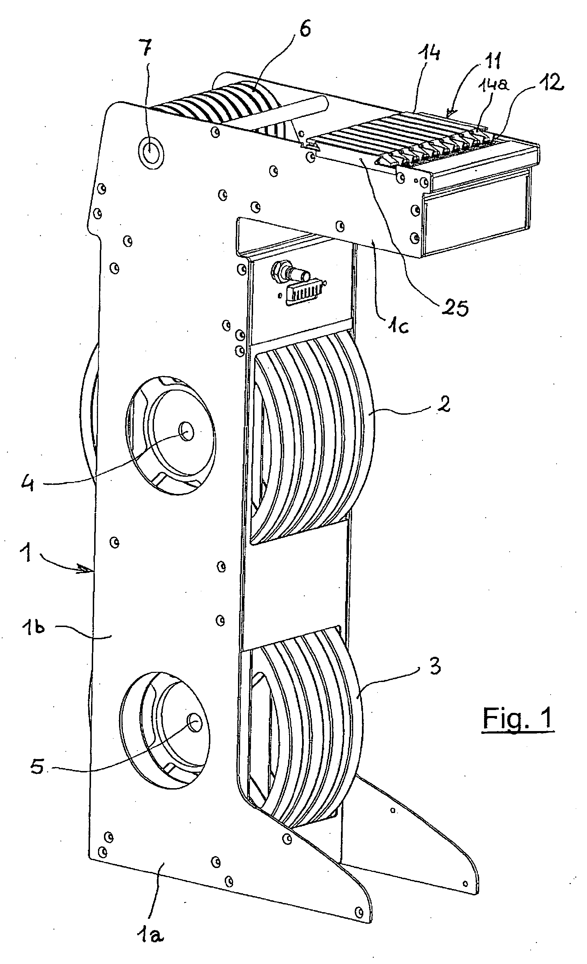

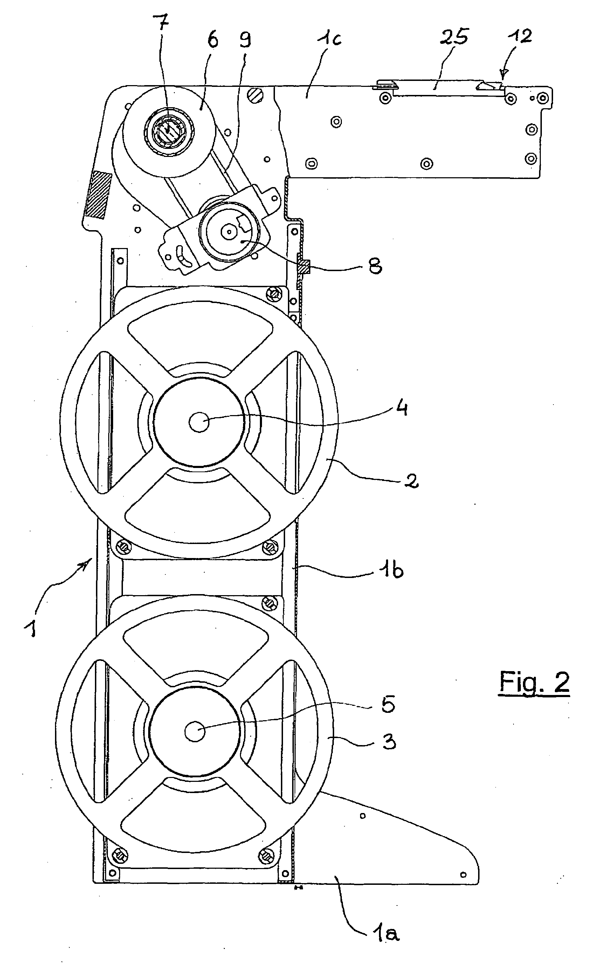

With reference to figures 1, 2 and 3, the numeral 1 generically indicates a rigid, box-type frame comprising a base portion 1a, an upright portion 1b rising from said base portion 1a, and a top portion 1c extending horizontally from the free end of the upright portion 1b. Inside the upright portion 1b there are two sets of reels 2 and 3 revolvingly mounted on respective spindles 4 and 5 supported on either side, at two different heights, by the upright portion 1b. The two sets of reels 2 and 3 are vertically staggered so as to avoid any interference between the tapes containing the SMD being unwound therefrom. At the upper end of the upright portion 1b, at the same height as the top portion 1c there is a shaft 7 whereon a battery of driving wheels 6 is integrally mounted for retrieving the coating film detached from the tape containing the SMD. The shaft 7 is connected to a geared motor 8 by means of a pulley transmission system (not shown) with a geared wheel 9, shown in figure 2.

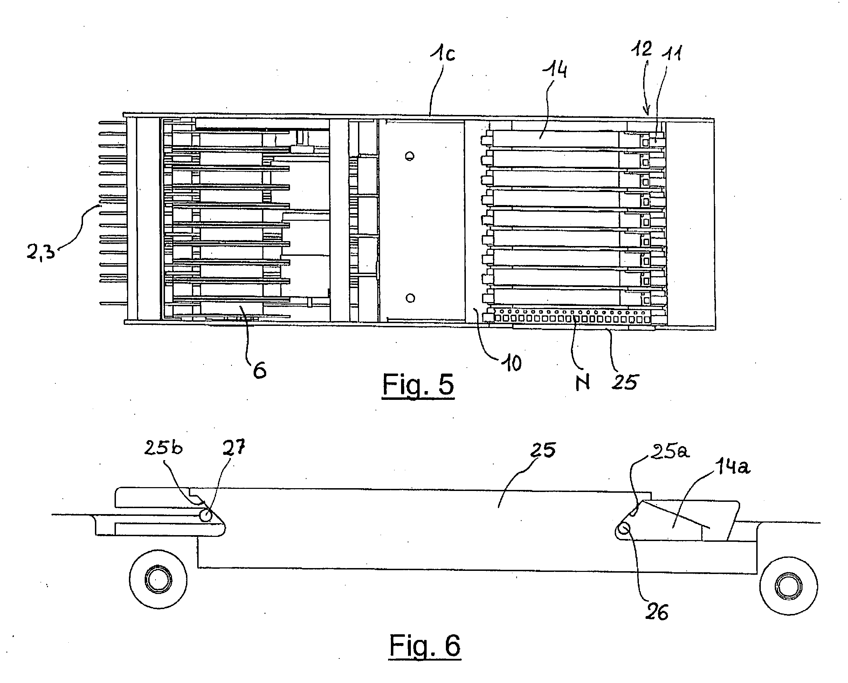

With reference also to figure 5, the top portion 1c comprises a horizontal bed 10 containing a plurality of longitudinal lanes 11, lying parallel to one another for the controlled feeding of the tape carrying the components towards a pickup area generically indicated by the numeral 12, situated at the free end of the top portion 1c. Inside the latter, underneath the bed 10, there is a device for feeding the tape forward, indicated generically by the reference number 13. The lanes 11 also contain respective film separators 14 consisting of suitably shaped bars, described in more detail later on.

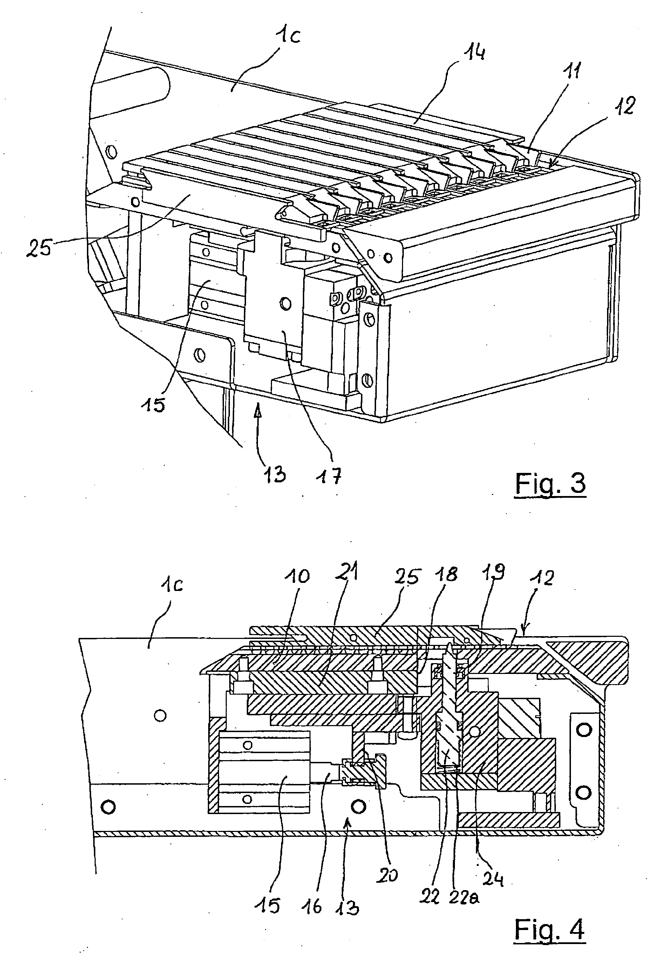

With particular reference to figures 3 and 4, the delivery device 13 comprises an actuator 15, which is pneumatic in the present embodiment of the invention, solidly attached to the bed 10 with a mobile stem 16 connected by means of a bracket 20 to a transverse carriage 17 and to a block 21 sliding inside a guide (not shown) that is integral to the bed 10. The carriage is longitudinally movable between two stops 18 and 19.

Inside the carriage 17, there is a row of pins 22 in a crosswise arrangement. The pins 22 have a body 22a that fits inside a seat 23 in the carriage 17 and they are designed so that their pointed end projects from a head 17a extending crosswise over the carriage 17. The pins 22 are arranged vertically with their pointed ends facing the lanes 11 and they are axially mobile within the carriage 17 so that they can selectively engage in or be disengaged from the guide holes aligned along at least one side of the tape carrying the SMD, a length of which (indicated by the letter N) is shown in figure 5. The axial movement of the pins 22 is controlled by pneumatic actuators 24.

The sliding lanes 11 have side walls 25 between which the film separators 14 are installed. As shown in detail in figure 6, the walls 25 frontally (i.e. in the area facing the pickup section 12) present an edge 25a that slopes in the opposite direction with respect to the pick up section 12 and, towards the bottom of the respective lane, against which a blocking pin 26 (that extends across the front end 14a of the separator 14) abuts. The end 14a of the separator 14 is substantially wedge-shaped so as to guide the coating film, which slides over the separator 14, coming up against its end 14a, after it has been detached from the tape carrying the SMD as a result of the tensile stress brought to bear by the respective film rewinding wheel 6 on which it is retrieved.

The opposite edge 25b of the walls 25 slopes in the opposite direction to edge 25a and serves as a striker for a second transverse pin 27 connected to a spring (not shown) contained longitudinally inside the separator 14.

The feeder according to the invention functions as explained below.

In the condition when the feeder is at rest, the tapes containing the SMD are placed inside respective lanes 11 and the protective film, already partly detached from the respective tapes, passes over the separators 14 and is wound around respective film-retrieving driving wheels, which are at a standstill. The carriage 17 is in its withdrawn position up against the rear stop 18, and the pins 22 are each engaged in a hole in the respective tape.

When a delivery signal is issued, the geared motor 8 turns the film-retrieving driving wheels 6, which draw the coating film taut. The tension on the film comes to bear on the ends 14a of the separators 14, which are thus drawn back. Given the restraining effect of the blocking pins 26 abutting against the sloping edges 25a, which makes the pins 26 slide along said edges, the separators 14 are pushed downwards and come to rest on the tapes, holding them pressed against the bottom of their respective lanes 11. Meanwhile, the tape-entraining pins 22 are withdrawn inside the carriage 17 to disengage them from the respective tapes with the exception of those engaged in the tapes selected for delivery. The carriage 17 advances to the front stop 19 entraining the tapes in which the selected pins 22 have remained engaged, while the drive wheels 6 continue to keep the film pulled taut.

Once the SMD have been collected, the tape-entraining pins 22 engaged in the selected tapes drop back into the carriage 17, thus becoming disengaged from the tape, and the carriage returns to the opposite end of its stroke 18, while the drive wheels 6 ensure the retrieval of the film detached from the selected tapes as a result of the delivery stroke. Then all the tape-entraining pins 22 re-emerge, hooking up the tapes again, while the film-retrieving drive wheels 6 stop and the feeder returns to its resting condition, ready for a new feeding cycle.

Thus, the tapes that do not need to move forward are kept at a standstill by the separators 14 due to the effect of the tension on the films, which would normally tend to displace them. This ensures the utmost precision and repeatability of the delivery cycles because the tapes that do not need to advance are hold in place, ensuring that there is no, even minimal movement on their part that could prevent the subsequent engagement of the tape-entraining pins in the holes in the tapes when the carriage is drawn back.

The second pin 27 exerts an auxiliary tensile action in the same direction as the one brought to bear by the film-retrieving wheels 6. This auxiliary action is useful both to reinforce the downward thrust towards the bottom of the lanes 11, which helps to hold the tapes fast therein, and to compensate for any (ultimately unavoidable) discrepancy in the turning speeds of the film-retrieving wheels 6. Finally, the combined and opposing action of the transverse pins 26 and 27 ensures the stable positioning of the separators 14 inside their respective lanes 11, preventing their accidental or unwanted displacement.

It should be noted, moreover, that the provision of a movement of the carriage 17 with a fixed stroke between the two stops 18 and 19 contributes simply and reliably to ensuring an excellent repeatability of exposure of the components. In addition, the assembly of the tapes on the feeder is straightforward and practical because the film separators are simply rested on the tapes and can consequently be promptly removed from their respective lanes, to allow for the positioning of the tapes, and then put back in place.

Variants and/or changes may be made to the linear multiple feeder for automatic SMD positioning machines according to the present invention without departing from the scope of the invention as set forth in the following claims.

## Claims

1. Linear multiple feeder for SMD automatic positioning machines, the SMD being arranged on a tape wound on a reel and protected with a coating film removably attached to said tape, which is separated therefrom to enable said SMD to be collected, comprising a supporting structure (1), a plurality of reels (2, 3) of tapes carrying the SMD revolvingly installed on said supporting structure, means (6) for the retrieval of the protective film detached from said tapes when said components are exposed for collection, a plurality of parallel lanes (11) for the delivery of said tapes provided on said supporting structure (1), downstream from said means for retrieving the film (6), a device (13) for the linear forward delivery of said tapes along said lanes, comprising a carriage (17) alternately moving between two stops (18, 19) and carrying a row of tape-entraining pins (22) selectively engageable in the tapes inside said lanes (11) so as to carry only the selected tapes forward as necessary, **characterized in that** there are respective elements (14) in between said lanes for separating the coating film, which is axially drawn along by said retrieval means (6), in the opposite direction to the delivery of the respective tape, in order to detach the film from the forward-moving tape, forcing it against said separator elements (14), the tension created in the coating film by said film retrieval means (6) being suitable for pushing said separators (14) against the bottom of their respective lanes and thereby prevent any movement of the tapes that have not been selected for delivery, by blocking them between said separators (14) and said bottom of the lane (11).

2. Multiple feeder according to claim 1, wherein the front end (14a) of said separator elements (14) abuts against the respective film under tensile stress, at least one locking pin (26) extending crosswise from said end and abutting against an edge (25a) of a side wall (25) of the respective lane (11), said edge (25a) sloping in the opposite direction to that of tape forward delivery in the lane (11) and leading downwards towards the bottom of said lane.

3. Multiple feeder according to claims 1 or 2, wherein a lateral wall (25) of each lane has a further edge (25b) that slopes in the opposite direction to the one against which said blocking pin (26) abuts, there being a further transverse pin (27) at the rear end of said separators (14) that abuts against said sloping edge, said transverse pin being elastically connected to the respective separator (14) to force against said further edge (25b).

4. Multiple feeder according to any of the previous claims, wherein said means for retrieving the film comprise respective coaxial drive wheels (6) installed on said supporting structure (1) and connected to motor means (8) that turn them.

5. Multiple feeder according to any of the previous claims, wherein said stops (18, 19) consist of two fixed abutment elements.

6. Multiple feeder according to any of the previous claims, wherein said front end (14a) of the separator elements (14), on which the relevant tensioned films abut, is substantially wedge shaped.

## Patentansprüche

1. Lineare Mehrfachzuführvorrichtung für automatische Positioniermaschinen für SMDs, wobei die SMDs auf einem Band, das auf eine Spule aufgewickelt ist, angeordnet und mit einem Beschichtungsfilm geschützt sind, der entfernbar an dem Band angebracht ist, das davon separiert ist, um es den SMDs zu ermöglichen, aufgenommen zu werden, enthaltend eine Stützstruktur (1), eine Mehrzahl von drehbar an der Stützstruktur installierten Spulen (2, 3) von Bändern, die die SMDs tragen, Einrichtungen (6) für die Zurückerlangung des Schutzfilms, der von den Bändern abgelöst ist, wenn die Komponenten zur Aufnahme freigelegt sind, eine Mehrzahl von parallelen, an der Stützstruktur (1) vorgesehenen Spuren (11) für die Zufuhr der Bänder, eine Vorrichtung (13) für die lineare Vorwärtszufuhr der Bänder längs der Spuren stromabwärts der Einrichtungen (6) zur Zurückerlangung des Films, enthaltend einen Schlitten (17), der sich alternierend zwischen zwei Stopps (18, 19) bewegt und eine Reihe von Bandmitnahmestiften (22) trägt, die selektiv mit den Bändern innerhalb der Spuren (11) in Eingriff bringbar sind, um in erforderlicher Weise nur die ausgewählten Bänder vorwärts zu befördern, **dadurch gekennzeichnet, dass** es zwischen den Spuren entsprechende Elemente (14) zum Separieren des Beschichtungsfilms gibt, der von den Zurückerlangungseinrichtungen (6) axial in der entgegengesetzten Richtung zur Zufuhr des jeweiligen Bandes der Länge nach gezogen wird, um den Film von dem sich vorwärts bewegenden Band abzulösen, was es gegen die Separatorelemente (14) drängt, wobei die Spannung, die in dem Beschichtungsfilm durch die Zurückerlangungseinrichtungen (6) erzeugt wird, geeignet ist, um die Separatoren (14) gegen den Boden ihrer jeweiligen Spuren zu drücken und **dadurch** jegliche Bewegung der Bänder zu verhindern, die nicht für eine Zufuhr ausgewählt wurden, indem sie zwischen den Separatoren (14) und dem Boden der Spur (11) blockiert werden.

2. Mehrfachzuführvorrichtung nach Anspruch 1, wobei das Vorderende (14a) der Separatorelemente (14) gegen den jeweiligen Film unter einer Zugbelastung anliegt, wobei wenigstens ein Sperrstift (26) sich kreuzweise von dem Ende erstreckt und gegen einen Rand (25a) einer Seitenwand (25) der jeweiligen Spur (11) anliegt, welcher Rand (25a) in der entgegengesetzten Richtung zu jener der Bandvorwärtszufuhr in der Spur (11) geneigt ist und abwärts zu dem Boden der Spur führt.

3. Mehrfachzuführvorrichtung nach Anspruch 1 oder 2, wobei eine Seitenwand (25) jeder Spur einen weiteren Rand (25b) hat, der in der entgegengesetzten Richtung zu derjenigen geneigt ist, gegen welche der Sperrstift (26) anliegt, wobei es am hinteren Ende der Separatoren (14) einen weiteren Querstift (27) gibt, der gegen den geneigten Rand anliegt, welcher Querstift elastisch mit dem jeweiligen Separator (14) verbunden ist, um gegen den weiteren Rand (25b) zu drängen.

4. Mehrfachzuführvorrichtung nach einem der vorhergehenden Ansprüche, wobei die Einrichtungen zum Zurückerlangen des Films koaxiale Antriebsräder (6) enthalten, die an der Stützstruktur (1) installiert und mit Motoreinrichtungen (8) verbunden sind, die sie drehen.

5. Mehrfachzuführvorrichtung nach einem der vorhergehenden Ansprüche, wobei die Stopps (18, 19) aus zwei fixierten Anlageelementen bestehen.

6. Mehrfachzuführvorrichtung nach einem der vorhergehenden Ansprüche, wobei das Vorderende (14a) der Separatorelemente (14), an welchem die relevant gespannten Filme anliegen, im wesentlichen keilförmig ist.

## Revendications

1. Dispositif d'alimentation linéaire multiple pour machines de positionnement automatique de DMS (*Dispositifs Montés en Surface*), les DMS étant disposés sur une bande enroulée sur une bobine et protégés par un film de recouvrement fixé de façon amovible sur ladite bande, qui en est séparé pour permettre aux dits DMS d'être collectés, comportant une structure porteuse (1), une pluralité de bobines (2, 3) de bandes transportant les DMS disposées de façon rotative sur ladite structure porteuse, des moyens (6) pour récupérer le film protecteur détaché des dites bandes quand lesdits composants sont exposés pour être collectés, une pluralité de voies parallèles (11) pour délivrer lesdites bandes aménagée sur ladite structure porteuse (1), en aval à partir des dits moyens de récupération du film (6), un dispositif (13) pour la distribution linéaire vers l'avant des dites bandes le long des dites voies, comprenant un chariot (17) se déplaçant alternativement entre deux butées (18, 19) et portant une rangée de goupilles d'entraînement de bande (22) pouvant s'engager sélectivement dans les bandes à l'intérieur des dites voies (11) afin de déplacer vers l'avant uniquement les bandes choisies selon les besoins, **caractérisé en ce que** sont prévus des éléments respectifs (14) dans lesdites voies pour séparer le film de recouvrement, qui est entraîné axialement par lesdits moyens de récupération (6), dans la direction opposée à la livraison de la bande respective, afin de détacher le film de la bande en déplacement vers l'avant, en le forçant à l'encontre des dits éléments séparateurs (14), la tension créée sur le film de recouvrement par lesdits moyens de récupération du film (6) étant apte à pousser lesdits séparateurs (14) contre le fond de leurs voies respectives et à empêcher de ce fait tout mouvement des bandes qui n'ont pas été choisies pour la livraison, en les bloquant entre lesdits séparateurs (14) et ledit fond de la voie (11).

2. Dispositif d'alimentation multiple selon la revendication 1, dans lequel l'extrémité avant (14a) des dits éléments séparateurs (14) vient buter contre le film respectif sous une force de traction, au moins une goupille de verrouillage (26) s'étendant en travers à partir de ladite extrémité et venant buter contre un bord (25a) d'une paroi latérale (25) de la voie respective (11), ledit bord (25a) s'inclinant dans la direction opposée à celle de la livraison vers l'avant de la bande dans la voie (11) et conduisant vers le bas vers le fond de ladite voie.

3. Dispositif d'alimentation multiple selon l'une des revendications 1 et 2, dans lequel une paroi latérale (25) de chaque voie présente un autre bord (25b) qui s'incline dans la direction opposée à celle du bord contre lequel vient buter la goupille de verrouillage (26), une autre goupille transversale (27) étant prévue à l'extrémité arrière des dits séparateurs (14) qui vient buter contre ledit bord en pente, ladite goupille transversale étant reliée élastiquement au séparateur respectif (14) pour forcer contre l'autre dit bord (25b).

4. Dispositif d'alimentation multiple selon l'une quelconque des revendications précédentes, dans lequel lesdits moyens de récupération du film comprennent des roues d'entraînement coaxiales respectives (6) agencées sur ladite structure porteuse (1) et reliées à des moyens moteurs (8) qui les font tourner.

5. Dispositif d'alimentation multiple selon l'une quelconque des revendications précédentes, dans lequel lesdites butées (18, 19) sont constituées de deux éléments de butée fixes.

6. Dispositif d'alimentation multiple selon l'une quelconque des revendications précédentes, dans lequel ladite extrémité avant (14a) des éléments séparateurs (14), sur laquelle les films tendus appropriés viennent buter, est sensiblement en forme de coin.
